(19) Europäisches Patentamt
European Patent Office
Office européen des brevets

(11) Publication number: 0 223 698 A2

# (12) EUROPEAN PATENT APPLICATION

(21) Application number: 86402495.5

(22) Date of filing: 07.11.86

(51) Int. Cl.⁴: H 01 L 23/52
H 01 L 21/90

(30) Priority: 14.11.85 US 798038

(43) Date of publication of application: 27.05.87 Bulletin 87/22

(84) Designated Contracting States: AT DE FR GB IT NL

(71) Applicant: THOMSON COMPONENTS-MOSTEK CORPORATION
1310 Electronics Drive
Carrollton Texas 75006 (US)

(72) Inventor: DiMarco, David P.
Thomson-CSF SCPI 9, avenue de Messine
F-75008 Paris (FR)

Towns, Martin D.
Thomson-CSF SCPI 9, avenue de Messine
F-75008 Paris (FR)

Mize, Jack P.
Thomson-CSF SCPI 9, avenue de Messine
F-75008 Paris (FR)

(74) Representative: Ruellan-Lemonnier, Brigitte et al
THOMSON-CSF SCPI 19, avenue de Messine
F-75008 Paris (FR)

## (54) Hillock immunization mask.

(57) An integrated circuit chip having metalization design features that result in greater device reliability. An integrated circuit chip has a plurality of semiconductor layers; at least one metalization layer; and at least one insulating layer which supports the metalization layer. The metalization layer has at least one metallic circuit component characterized in that it has the form of a group of substantially parallel electrically interconnected metallic strips. These metallic strips have a predetermined width and are spaced apart by a predetermined separation distance.

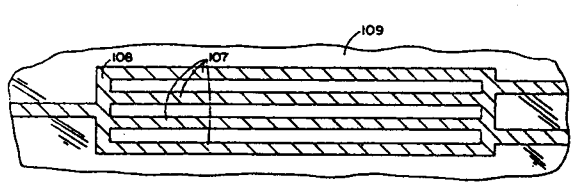

FIG. 3

EP 0 223 698 A2

## Description

### Hillock Immunization Mask

Technical Field

The field of art to which this invention pertains is integrated circuits having a layer of metalization superimposed on a layer of insulation.

Background Art

In this modern era, semiconductor chips are used in a variety of applications including automobiles, household appliances and machinery, as well as in computers. Thus, the developed nations have come to rely on semiconductor chips for their day-to-day living and this reliance can only be expected to increase in future years. Fueling the demand for semiconductor chips from the supply side, are the many advances that have been made including the increases in memory capability, speed, reliability and the simultaneous decrease in cost.

One material-design advancement in semiconductor chips is the double-level metalization circuitry. Double-level metal circuitry relates to the utilization of two metallic layers above and below the semiconducting material instead of the conventional single metallic layer. The first layer of metal is in the form of a series of strips standing up above an insulating layer. An intermediate insulating layer is placed above the first layer of metal and a second layer of metal is placed on top of it. These double-level metalization semiconductor chips have several advantages.

Double-level metalization interconnections aid in attaining a small chip size and high speed. The importance of multilevel metalizations in achieving the above two desired characteristics can be appreciated by recognizing the fact that the Very Large Scale Integrated Circuit (VLSIC) chip size and speed performance is now limited by the interconnect technology, rather than by device scaling. The length and resistivity of the interconnect layers are thus two key factors which affect the overall performance of present and future VLSICs. To illustrate this point, a simple expression for the Resistance X Capacitance (RC) time delay associated with an interconnect placed on an oxide or other insulating film is given by:

$$RC = \frac{\rho L^2 K}{t_{ox}} \quad \text{(Eq. 1)}$$

where:
L = Length of the interconnect
ρ = sheet resistivity of the interconnect
K = dielectric constant of the oxide or other insulating film
$t_{ox}$ = thickness of oxide or other insulating film

Since the length L, appears as a squared term in Eq. 1, the need for multilevel metalizations which permit the length of a multilevel interconnect to be minimal (rather than meander in a highly constrained manner over and about the chip as is typical of single layer interconnects) is evident.

Although double-level metal devices have many advantages, they like other semiconductor devices can experience malfunctions, i.e. production yields of usable chips can be low. For instance, in double-level metalization, it is important that the intermediate insulating layer maintain its integrity to avoid short circuits, or signal feedthrough between the two layers of metal. It is also important that the second metallic level be continuous as it passes over the step in the insulating layer that is caused by the projection of the first metal level. A number of techniques are known in the art to make the surface of the intermediate insulator more smooth, note commonly-assigned U.S. Patent No. 4,508,815 the disclosure of which is hereby incorporated by reference, however double-level metallized circuits can still have reliability problems. Given the importance and widespread use of semiconductor chips, it is desirably to have chips that can be made in yields having fewer defects.

Accordingly, there has been a constant search in this field of art for double-level metalization layers that have greater reliability.

Disclosure of Invention

This disclosure is directed to integrated circuit chips having metalization design features that result in greater device reliability. An integrated circuit chip has a plurality of semiconductor layers; at least one metalization layer; and at least one insulating layer which supports the metalization layer. The metalization layer has as least one metallic circuit component characterized in that it has the form of a group of substantially parallel electrically interconnected metallic strips. These metallic strips have a predetermined width and are spaced apart by a predetermined separation distance.

This invention provides a surprising material-design modification, for example, to double-level metalization semiconductor chips that can eliminate a substantial amount of device malfunctions and thus increase the

yields of usable semiconductor chips. Thus, this invention makes a significant advance in the field of multi-level metalization in particular and the semiconductor industry in general.

The foregoing and other objects, features and advantages will be aparent from the specification and claims from the accompanying drawing which will illustrate an embodiment of the invention.

Brief Description of Drawings

Figure 1 is a top view of several circuits having hillocks,

Figure 2 is a cross-section view of double-level metalization including a hillock,

Figure 3 is a schematic view of an exemplary component (a busbar) of the present invention.

Figure 4 is a graph detailing the relationship between line widths of about 4 microns to about 50 microns and concentration of hillocks.

Figure 5 is a graph detailing the relationship between line widths of 1 to 4 microns and concentration of hillocks.

Figure 6 is a schematic view of an exemplary component (a capacitor plate) of the present invention.

Best Mode for Carrying Out the Invention

Metals typically aluminum alloys (as later defined) are used to form metallic circuit components such as busbars. The busbars include the $V_{cc}$ and $V_{ss}$lines which distribute current throughout the chip. These busbars which have line widths greater than 10 microns are important to the formation of hillocks. Hillocks are defined as a protuberance of a layer of metal that may, in formation, be capable of pushing through at least one layer of material that covers and is bonded to the layer of metal. A clearer understanding of this may be had by reference to the figures. Figure 1 shows a plurality of circuits 101 having hillocks 102 on their surface. Figure 2 details the cross section of a hillock 102. In that figure the first metal layer 103 has pushed up through the intervening layer of insulating material 104 and connected to the second layer of metal 105 at a point 106 where it forms a short circuit.

Conventional busbars have widths of 10 microns to a few hundred microns. These dimension are dictated by the metalization system used and the amount of current carried which is typically orders-of-magnitude greater than the amount carried by the fine-line metal interconnections for signal propagation within the integrated circuit. Surprisingly, it has been found the large dimension width of the busbar necessitated by the requisite current is proportional to the amount of hillocks per square centimeter (hillocks/$cm^2$) of metal area. Thus, it is critical to reduce the width of the bus bar in order to reduce hillock formation. In order to maintain the current carrying capacities typically required, a series of strips connected in parallel may be utilized in place of the present busbars (which have a large width). Accoring to Fig. 3, in place of the present busbars, it is preferred to have a plurality of lines (i.e. metallic strips) 107 connected in parallel 108; each metallic strip having a predetermined width less than about 10 microns supported by an insulating layer such as silicon dioxide 109. It is believed this width provides the maximum amount of hillocks that can be tolerated in a semiconductor chip used for conventional purposes. It is especially preferred to use metallic strips having a width less than about 3 microns because this provides about $2 \times 10^5$ hillocks/$cm^2$ and at this level of hillocks/$cm^2$, it is believed a commercially acceptable yield of usable chips is obtained. In addition, the metallic strips are typically spaced apart by a predetermined distance that depends on at least two factors. The metallic strips should be as close as possible to reduce the size of the metallic component and yet not so close as to affect electrical shorts or increase the concentration of hillocks. Although this preferred separation distance can vary, it should be as small as possible to reduce component size. It is typically about 0.5 microns to about 3 microns and preferably about 1 micron as it can be difficult to define anything smaller by present techniques.

Preferably the substantially parallel metallic strips are intersected by at least one set of substantially parallel interconnected metallic strips to form an interconnected grid (framework) of metallic strips on the insulating surface. This helps to reduce the component size as less space is required for an equivalent amount of metal area (e.g., current carrying capacity). Yet the benefit of a reduced number of hillocks is still obtained. Again, the metal strip widths are preferably less than 10 microns and it is especially preferred that they are less than 3 microns as this results in fewer hillocks. These metal strips should be spaced apart by similar distances as the first set of metallic strips. In addition, the angle of intersection may vary.

Typically, in the process (described below) of forming busbars, the busbars undergo thermal cycling. For example, after the aluminum is deposited on the silicon, the temperature is elevated in order that the naturally occurring silicon oxide layer which covered the silica can react with the aluminum to form alumina ($Al_2O_3$) and silica, particularly at the oxide contact holes. Empirically, this can be illustrated as $Al + SiO_2 \rightarrow Al_2O_3 + Si$. This sintering (i.e. annealing, alloying) step is required for forming aluminum-silicon electrical contacts possessing acceptable ohmicity. Other beneficial effects to the electrical characteristics of MOSFET active devices in VLSICs are further derived in this same elevated temperature sintering process step. Although not wanting to be held to any theory, it is believed that these same annealing process steps create interfacial stresses between the aluminum and Si-$SiO_2$. The induced stress causes the thin metal film structures (interconnects) to creep and aluminum mass transport takes place resulting in hillock formation. These stresses are directly proportional to the differences in the thermal expansion properties of the metalization layers and the underlying semiconductor materials. An equation illustrative of the general physical principles of the situation is given by:

$$\text{Stress} = (\Delta T)\ (\alpha_{Al} - \alpha_{Si})\ E_{Al}$$

where α is the coefficient of thermal expansion E is the Young's Modulus and ΔT is the change in temperature. What is especially surprising about this invention is that the above relationships are independent of dimensions. Thus, according to the teachings of the prior art, the amount of stress and therefore, the amount of hillock formation should not depend upon any units of measurement. In contrast, however, it has been found that amount of hillocks/$cm^2$ of metal area is proportional to the line width size.

In addition, it has been found that there is a criticality associated with this proportionality relationship. A clear understanding of this proportionality and the criticality may be had by reference to Figure 4 which details the amount of hillocks x $10^6$/$cm^2$ of metal area y as a function of line width in microns x. Surprisingly, at approximately 10 microns the concentration of hillocks drops radically and it is believed that below about 3 microns a concentration level of hillocks is achieved that results in commercially viable chip yields. Fig. 5 also details the amount of hillocks x $10^5$/$cm^2$ of metal area y as a function of line width in microns x. In this figure the amount of hillocks continues to decrease as line width decreases from about 3 microns to about 1 micron. In addition to decreasing the amount of hillocks/$cm^2$ of metal area this invention also results in smaller hillocks. As the size of the hillocks increases, the probability of an electrical short from the first metal layer to the second metal layer increases. Thus, this invention reduces the probability of having an electrical short between the two metal layers by reducing the size and number of hillocks.

These spaced-apart parallel connected double-level metalization strips each of which have cross-section line widths less than about 3 microns can be used to advantage in place of any integral busbar interconnects having cross section widths greater than 10 microns. Thus, it is envisioned that a configuration of metal strips 3 microns wide, arrayed in parallel, sufficient in number to carry the current which is equal to that carried by the circuit, the parallel strips are replacing, would be used. The size of a busbar or other interconnection line depends in a conventional manner, known to those skilled in the art, on the resistivity of the metal, the amount of current that must be carried, and the RC time constant that is tolerable in the particular situation. In an illustrative example, an alloy having a resistivity of 5 micro ohm-centimeter is used that is required to conduct 50 milliamps. Conventional engineering practice would require that the width of the busbar be about 200 microns for a thickness of 0.5 microns. A typical busbar having a width of 100 microns and carrying a current of 50 milliamps could be replaced by 33 three micron wide interconnect strips spaced apart and connected in parallel.

The ohmic relationship of this parallel array of metallic, conductive strips is,

$1/R_B = 1/R_1 + 1/R_2 + 1/R_3...1/R_n$ (Eq. 3)

where

$R_B$ is the resistance of the busbar;

$R_1...R_n$ is the resistance of each discrete parallel connected current carrying strip interconnect of typically 3 micron width.

Although this disclosure has been directed to busbars, the concept can be used to advantage for other metallic circuit components. These include, but are not limited to, capacitor plates, input pads, electronic configurations that utilize multi-level metallic cross over configurations (e.g., inductor) and generally any metal component having a large level width. In addition, other arrangements besides parallel strips such as a grid arrangement may be used. A schematic of an exemplary capacitor plate is given in Fig. 6. Parallel electrically connected intersecting metallic strips 110 are supported by an insulating layer 111.

Generally, any metal, alloy or combination thereof may be used in the practice of this invention that is compatible with the semiconductor environment, provides the conventional properties desired of those metals used in semiconductor chips and results in the circuits of this invention which have less hillocks/$cm^2$ of metal area. It is preferred to use aluminum or alloys of aluminum to form said interconnecting lines and busbars. The choice of these materials arises from their advantageous metallurgical and electrical properties such as:

1. Low resistivity of interconnections
2. Adherence of the metal interconnections to oxide insulating layers
3. Low ohmic-nonrectifying contacts to silicon
4. Stability of contacts (both electrically and physically) to other conducting layers
5. Capability of being defined in fine pattern geometry with the photolithographic process
6. Etchability by means of plasma methods
7. Resistance to electromigration
8. VLSIC process economy

By alloys of aluminum is meant materials having aluminum present in greater than a 90 percent by weight (%) amount. Thus, aluminum may be alloyed with other materials such as about 0% to about 3% preferably about 0.5% copper and about 0% to about 3% preferably about 1% silicon. It is especially preferred to use higher percentages of copper, for example, 3% copper in the alloy as this can result in fewer hillocks/$cm^2$ of metal interconnect line area. However, an alloy with copper content as high as 3% can be difficult to define geometrically by modern-day plasma etch techniques. Typically, any insulating material may be used in this invention that is compatible with the semiconductor environment, and when utilized with the components which comprise metallic strips of this invention (e.g. silicon dioxide) results in a significant reduction in metal hillocks/$cm^2$.

These metallic strips are deposited on a layer typically an insulating layer using conventional semiconductor chip process technology such as sputtering or evaporation.

This hillock prevention design makes a significant advancement in the field of double level metalization semiconductor chips. The reduction of hillocks in, for example, busbars of semiconductor chips allows the utilization of double-level metalization resulting in chips that have greater speed, less malfunctions because of fewer junctions, and greater flexibility in terms of interconnect routing. This has been accomplished by the recognition of the hillock problem and how it can be solved with a surprisingly simple design alternative. Although simple, this design alternative is in total contrast to what basic material theory would hold. In addition, this design alternative is in contrast to basic device design as it can require more space and it can slow switching speed. Thus, this invention provides a surprising breakthrough in the field of double level metalization and to the semiconductor industry.

It should be understood that the invention is not limited to the particular embodiment shown and described herein, but that various changes and modifications may be made without departing from the spirit and scope of this concept as defined by the following claims.

## Claims

1. An integrated circuit chip having a plurality of semiconductor layers;
at least one metalization layer having metallic circuit components formed therein; and
at least one insulating layer supporting said metalization layer, characterized in that:
said at least one metallic circuit component has the form of a plurality of substantially parallel electrically interconnected metallic strips having a predetermined width and spaced apart by a predetermined separation distance on the surface of said insulating layer.

2. The chip as recited in claim 1, wherein said at least one component is a plate of a capacitor.

3. The integrated circuit chip as recited in claim 1 wherein the group of substantially parallel interconnected metallic strips are intersected by a plurality of substantially parallel interconnected metallic strips having a predetermined width and spaced apart by a predetermined separation distance on the surface of said insulating layer wherein a grid is formed.

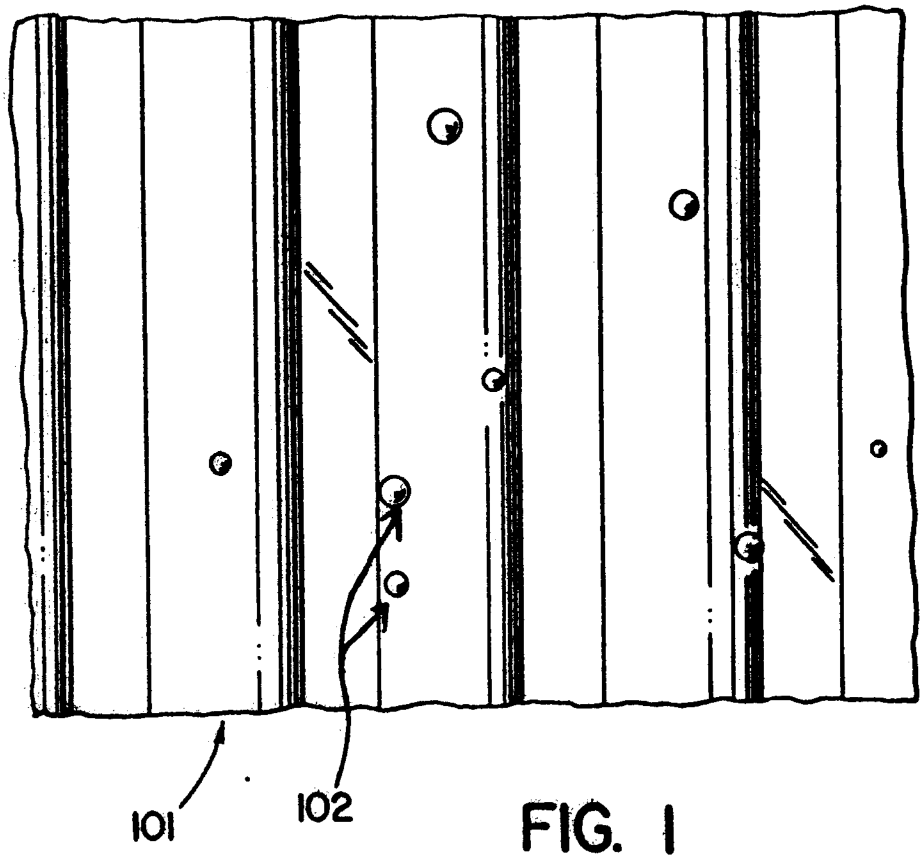


FIG. 1

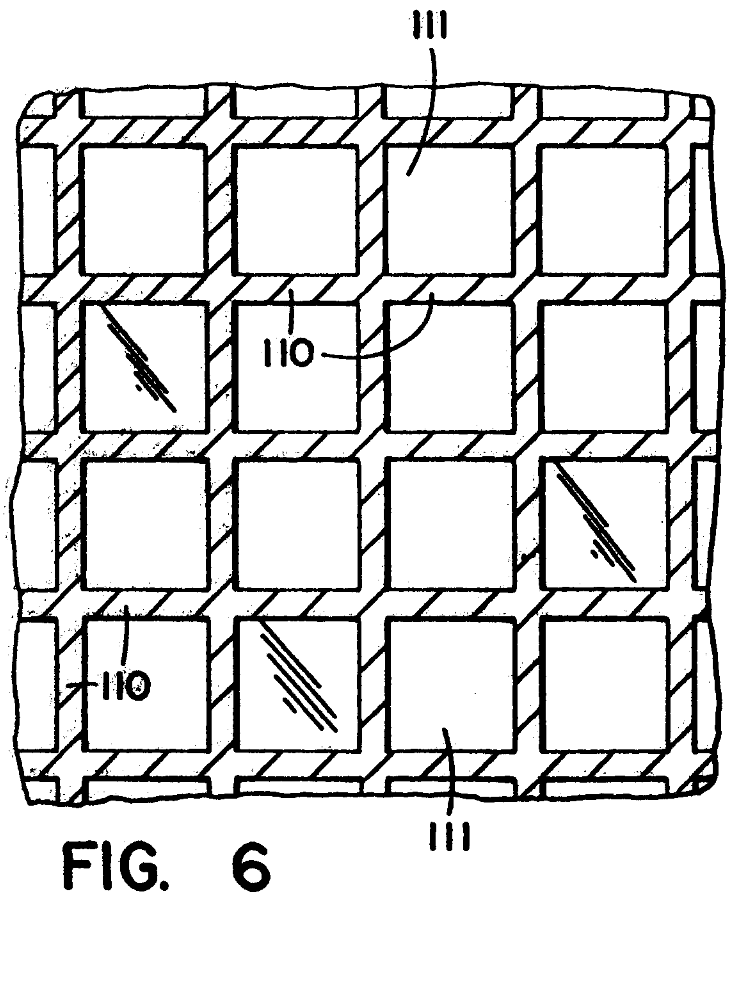


FIG. 6

0223698

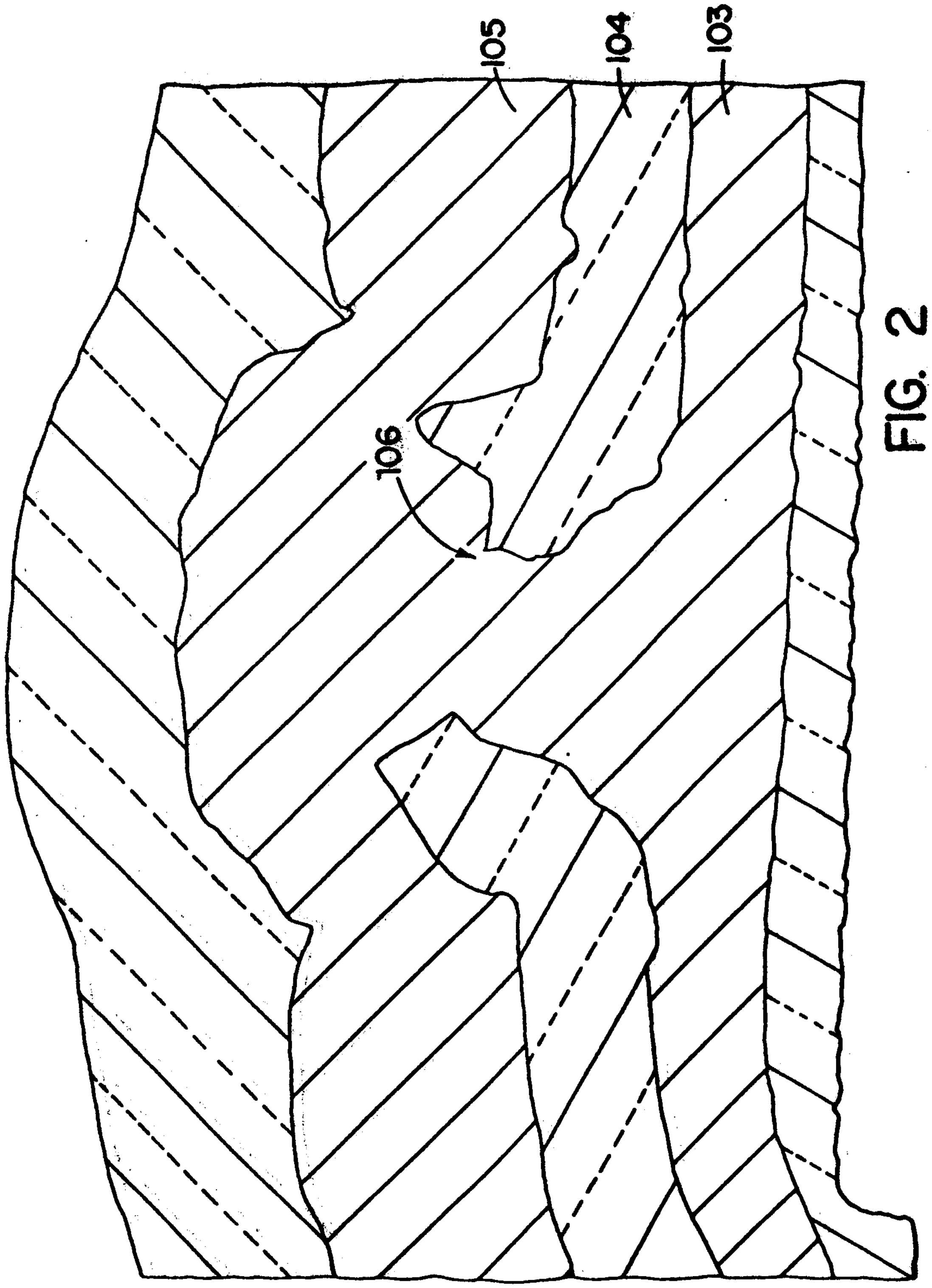


FIG. 2

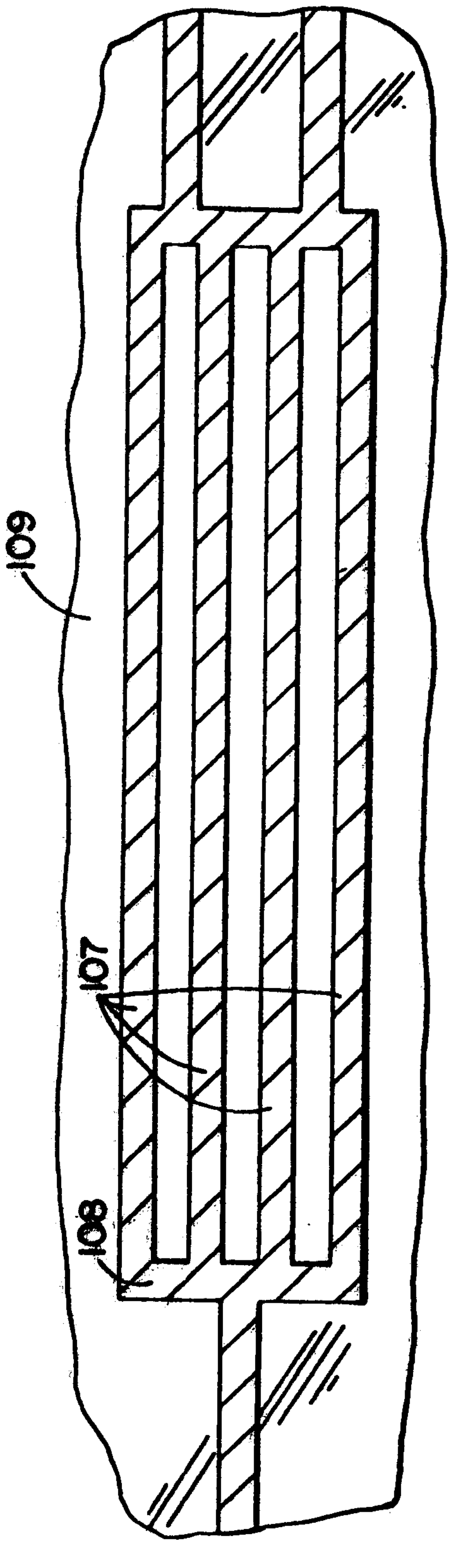


FIG. 3

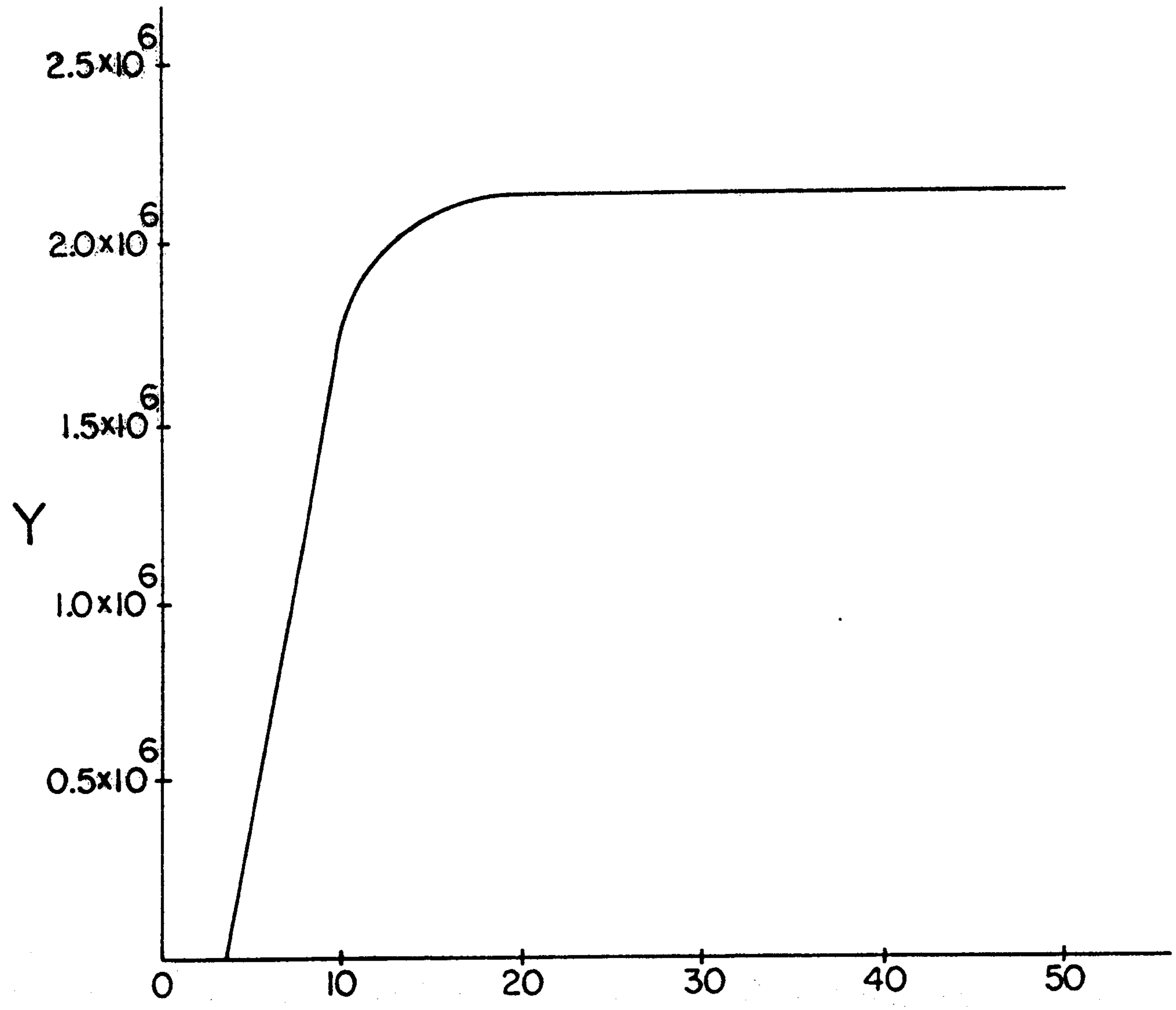


FIG. 4

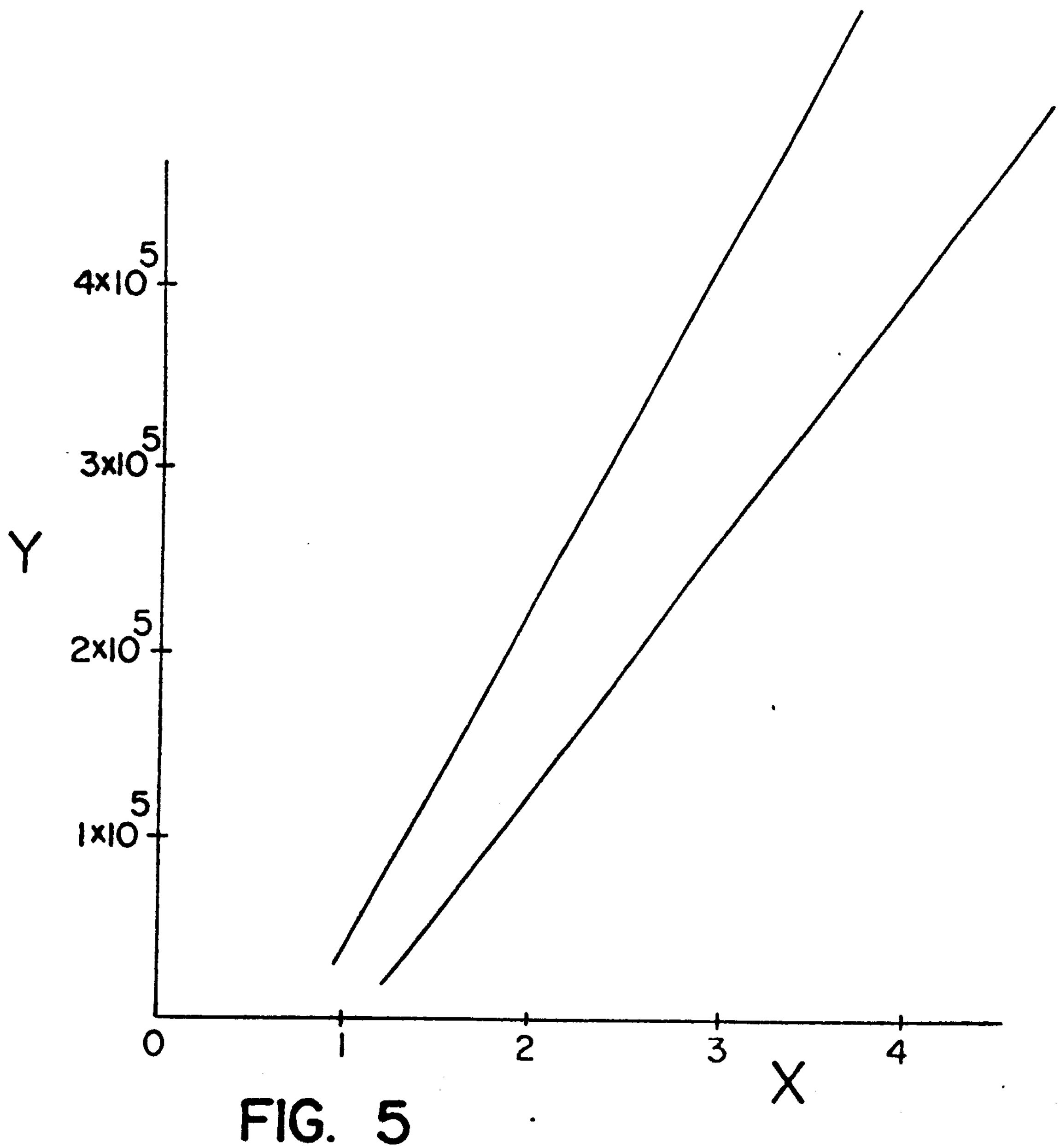


FIG. 5